# EUROPEAN PATENT APPLICATION

(11) **EP 4 432 355 A1**
(43) Date of publication of application: **18.09.2024**
(21) Application number: 22892113.6
(22) Date of filing: 11.11.2022
(51) Int. Cl.: H01L 25/11, H05K 7/20, H02M 7/48

(54) **SEMICONDUCTOR POWER MODULE, ELECTRIC MOTOR CONTROLLER AND VEHICLE**

(30) Priority: 12.11.2021 CN 202111342964
(71) Applicant: BYD Semiconductor Company Limited, Shenzhen, 518119 (CN)
(72) Inventor: ZHOU, Yuqi, Shenzhen, Guangdong 518119 (CN); LIU, Chunjiang, Shenzhen, Guangdong 518119 (CN); ZHANG, Jianli, Shenzhen, Guangdong 518119 (CN)
(74) Representative: Gulde & Partner
(86) International application number: PCT/CN2022/131480
(87) International publication number: WO 2023/083320

(57) **Abstract**

A semiconductor power module, a motor controller, and a vehicle are disclosed. The semiconductor power module includes: a substrate; a first conductive region, a second conductive region, a third conductive region and a fourth conductive region that are disposed on the substrate; a first power chip, a second power chip and a third power chip. The first conductive region and the second conductive region extend along the first direction of the substrate and are arranged along the second direction of the substrate, the third conductive region and the fourth conductive region are located between the first conductive region and the second conductive region and are arranged along the first direction. The first conductive region, the second conductive region and the third conductive region are configured to transmit a direct current signal, and the fourth conductive region is configured to transmit an alternating current signal.

## Description

### CROSS-REFERENCE TO RELATED APPLICATIONS

The present application claims the priority to the Chinese patent application No. 202111342964.0 entitled "SEMICONDUCTOR POWER MODULE, MOTOR CONTROLLER, AND VEHICLE" and filed with the China National Intellectual Property Administration on November 12, 2021, the entirety of which is incorporated herein by reference.

### TECHNICAL FIELD

The present disclosure relates to the field of vehicle technology, more particularly, to a semiconductor power module, motor controller, and vehicle.

### BACKGROUND

In related technology, a semiconductor power module uses a rectangular-ambulatory-plane arrangement, and during operation, internal circuits therein are directly coupled along the current flow to generate mutual inductance. Although the inductance can be reduced to a certain extent, it is easy to cause heat increase while the inductance is reduced, and to decrease the current output capacity, since internal chips of the semiconductor power module are arranged compactly within in a whole conductive region.

### SUMMARY

The present disclosure aims to solve at least one of the technical problems existing in the prior art. Therefore, a first purpose of the present disclosure is to propose a semiconductor power module which can form a mutual inductance within it to serve to counteract the inductance, thereby reducing the inductance in the entire module, and improving the heat-dissipation of the module.

A second purpose of the present disclosure is to propose a motor controller.

A third purpose of the present disclosure is to propose a vehicle.

In order to achieve the above purposes, a semiconductor power module is provided according to an embodiment in a first aspect of the present disclosure. The semiconductor power module includes:
a substrate having a first direction and a second direction that are orthogonal to each other;
a first conductive region, a second conductive region, a third conductive region and a fourth conductive region that are disposed on the substrate and that are spaced apart from each other, wherein the first conductive region and the second conductive region extend along the first direction of the substrate and are arranged along the second direction of the substrate, the third conductive region and the fourth conductive region are located between the first conductive region and the second conductive region and are arranged along the first direction, and wherein the first conductive region, the second conductive region and the third conductive region are configured to transmit a direct current signal, and the fourth conductive region is configured to transmit an alternating current signal; and
at least one first power chip, at least one second power chip and at least one third power chip, the first power chip is electrically connected to each of the first conductive region and the fourth conductive region, the second power chip is electrically connected to each of the second conductive region and the fourth conductive region, and the third power chip is electrically connected to each of the fourth conductive region and the third conductive region.

According to the semiconductor power module of the present disclosure, based on the layout design of the first conductive region, the second conductive region, the third conductive region and the fourth conductive region, the first power chip is electrically connected to each of the first conductive region and the fourth conductive region, the second power chip is electrically connected to each of the second conductive region and the fourth conductive region, and the third power chip is electrically connected to each of the fourth conductive region and the third conductive region. Thereby, after the circuit is connected, the first power chip and the second power chip are correspondingly electrically connected to the first conductive region, the second conductive region and the fourth conductive region, so as to form a first bridge arm of a half-bridge circuit. The third power chip is electrically connected to the fourth conductive region and the third conductive region to form a second bridge arm of the half-bridge circuit. Mutual inductance is formed between the first bridge arm and the second bridge arm to thereby reduce the parasitic inductance of the entire module. In addition, based on the layout design of the first conductive region, the second conductive region, the third conductive region, and the fourth conductive region, some first power chips, some second power chips, and some third power chips are uniformly arranged in the three conductive regions, with good heat-dissipation performance, simple structure, and a high integration degree.

In some embodiments, the first conductive region, the second conductive region and the third conductive region are configured to receive the direct current signal, and the fourth conductive region is configured to output the alternating current signal.

In some embodiments, the substrate has a first edge, a second edge, a third edge and a fourth edge that are connected in a sequential and head to tail manner, the first edge and the third edge are disposed opposite to each other in the second direction, and the second edge and the fourth edge are disposed opposite to each other in the first direction. The first conductive region is disposed adjacent to each of the first edge, the second edge and the fourth edge, the second conductive region is disposed adjacent to each of the third edge, the second edge and the fourth edge, the third conductive region is disposed adjacent to the second edge, and the fourth conductive region is disposed adjacent to the fourth edge.

In some embodiments, the third conductive region extends between the first conductive region and the second conductive region along the second direction and is disposed adjacent to one end of the first conductive region and one end of the second conductive region that receive the direct current signal.

In some embodiments, the fourth conductive region extends between the first conductive region and the second conductive region along the first direction and is disposed adjacent to another end of the first conductive region and another end of the second conductive region.

In some embodiments, each of the first conductive region and the second conductive region includes: a first conductive portion, a second conductive portion and a third conductive portion that are connected in sequence along the first direction. The first conductive portion is configured to receive the direct current signal, the third conductive portion protrudes, in comparison to the second conductive portion, towards the fourth conductive region. The first power chip is connected to the third conductive portion of the first conductive region, the second power chip is connected to the third conductive portion of the second conductive region, and the third power chip is located between the first conductive portion and the second conductive portion in the first direction.

In some embodiments, an edge of the second conductive portion of the first conductive region that faces away from the third conductive region is flush with an edge of the third conductive portion of the first conductive region that faces away from the fourth conductive region, and the third conductive portion of the first conductive region has a width that is greater than a width of the second conductive portion of the first conductive region. An edge of the second conductive portion of the second conductive region that faces away from the third conductive region is flush with an edge of the third conductive portion of the second conductive region that faces away from the fourth conductive region, and the third conductive portion of the second conductive region has a width that is greater than a width of the second conductive portion of the second conductive region.

In some embodiments, an edge of the first conductive portion of the first conductive region that faces away from the third conductive region is flush with an edge of the second conductive portion of the first conductive region that faces away from the fourth conductive region, and the first conductive portion of the first conductive region has a width that is greater than a width of the second conductive portion of the first conductive region. An edge of the first conductive portion of the second conductive region that faces away from the third conductive region is flush with an edge of the second conductive portion of the second conductive region that faces away from the fourth conductive region, and the first conductive portion of the second conductive region has a width that is greater than a width of the second conductive portion of the second conductive region.

In some embodiments, the third conductive region includes: a first converging conductive portion extending in the second direction and configured to receive the direct current signal; and a plurality of first conductive branches connected with the first converging conductive portion and extending towards the fourth conductive region in the first direction. The first conductive branch is located between the second conductive portion of the first conductive region and the second conductive portion of the second conductive region, and the third power chip is connected to the first conductive branch of the third conductive region.

In some embodiments, the fourth conductive region includes: a second converging conductive portion extending in the first direction and configured to output the alternating current signal; a plurality of second conductive branches connected with the second converging conductive portion and extending towards the third conductive region in the first direction. The second converging conductive portion is located between the third conductive portion of the first conductive region and the third conductive portion of the second conductive region, the first power chip and the second power chip are connected to the second converging conductive portion of the fourth conductive region, the second conductive branch is located between the second conductive portion of the first conductive region and the second conductive portion of the second conductive region, and the third power chip is connected to the second conductive branch of the fourth conductive region.

In some embodiments, the plurality of the first conductive branches and the plurality of the second conductive branches are arranged alternately along the second direction, and the first conductive branch and the second conductive branch that are adjacent to each other are connected through the third power chip.

In some embodiments, the first conductive branch and the second conductive branch that are adjacent to each other are connected by a plurality of third power chips that are spaced apart along the first direction, the third power chips located on two outermost sides in the second direction are same in quantity.

In some embodiments, the first conductive region has a first direct current connection point for receiving the direct current signal, the second conductive region has a second direct current connection point for receiving the direct current signal, the third conductive region has a third direct current connection point for receiving the direct current signal, and the fourth conductive region has an alternating current connection point. The first direct current connection point, the second direct current connection point and the third direct current connection point are disposed on one side of the substrate in the first direction and are arranged in the second direction, the third direct current connection point is disposed between the first direct current connection point and the second direct current connection point, a polarity of the direct current signal connected to the first direct current connection point is the same as a polarity of the direct current signal connected to the second direct current connection point, a polarity of the direct current signal connected to the third direct current connection point is opposite to a polarity of the direct current signal connected to the first direct current connection point, and the alternating current connection point is located on the other side of the substrate in the first direction.

In some embodiments, the first direct current connection point and the second direct current connection point are anodic direct current connection points and the third direct current connection point is a cathode direct current connection point; and the first power chip is provided in the first conductive region and is electrically connected to the fourth conductive region, the second power chip is provided in the second conductive region and is electrically connected to the fourth conductive region, and the third power chip is provided in the fourth conductive region and is electrically connected to the third conductive region.

In some embodiments, the first direct current connection point and the second direct current connection point are cathode direct current connection points and the third direct current connection point is an anodic direct current connection point. The first power chip is provided in the fourth conductive region and is electrically connected to the first conductive region, the second power chip is provided in the fourth conductive region and is electrically connected to the second conductive region, and the third power chip is provided in the third conductive region and is electrically connected to the fourth conductive region.

In some embodiments, a plurality of third power chips are included and the plurality of the third power chips are arranged in the first direction or the second direction.

In some embodiments, the first power chip and the second power chip are arranged in the second direction; and a plurality of first power chips are included, a plurality of second power chips are included, and the plurality of the first power chips are arranged in the same direction as that of the plurality of the second power chips.

In some embodiments, the first power chip and the third power chip are arranged along the first direction; and the second power chip and the third power chip are arranged along the first direction.

In some embodiments, a sum of the number of the at least one first power chip and the number of the at least one second power chip is equal to the number of the at least one third power chip.

In some embodiments, the first conductive region is connected to the fourth conductive region via a plurality of the first power chips that are spaced apart in the first direction, the second conductive region is connected to the fourth conductive region via a plurality of the second power chips that are spaced apart in the first direction, and the plurality of the first power chips and the plurality of the second power chips are disposed in one-to-one correspondence in the second direction.

In some embodiments, the semiconductor power module further include: an insulating cover body mounted on the substrate and covering the first conductive region, the second conductive region, the third conductive region, the fourth conductive region, the at least one first power chip, the at least one second power chip and the at least one third power chip.

A motor controller is provided according to an embodiment in a second aspect of the present disclosure. The motor controller includes: a heat-dissipating base plate and a cooling liquid channel, the heat-dissipating base plate mounted to the cooling liquid channel; and the semiconductor power module according to the above embodiment, the semiconductor power module is disposed on the heat-dissipating base plate.

According to the motor controller of the present disclosure, by adopting the semiconductor power module that is provided in the above embodiment and that is provided on the heat-dissipation base plate, the stray inductance in the circuit can be effectively reduced and the heat-dissipation is good.

A vehicle is provided according to an embodiment in a third aspect of the present disclosure. The vehicle includes: a motor; and the motor controller according to the above embodiment. The motor controller is connected to the motor.

According to the vehicle of the present disclosure, by using the motor controller provided in the above embodiment, the inductance can be reduced and heat-dissipation can be improved.

The additional aspects and advantages of this application will be provided in the following description, which will become apparent from the following description, or will be learned through the practice of this application.

### BRIEF DESCRIPTION OF DRAWINGS

The above and/or additional aspects and advantages of the present disclosure will become apparent and easy to understand from the description of embodiments in conjunction with the accompanying drawings, in which:
FIG. 1 is a schematic diagram of a semiconductor power module according to an embodiment of the present disclosure;
FIG. 2 is a schematic diagram showing a current flow direction of a semiconductor power module according to an embodiment of the present disclosure;
FIG. 3 is a schematic diagram of a semiconductor power module according to another embodiment of the present disclosure;
FIG. 4 is a schematic diagram of a power chip that is bonded with copper according to an embodiment of the present disclosure;
FIG. 5 is a schematic diagram of a semiconductor power module according to yet another embodiment of the present disclosure;
FIG. 6 is a top view of a semiconductor power module according to an embodiment of the present disclosure;
FIG. 7 is a schematic diagram showing a plastic packaged semiconductor power module according to an embodiment of the present disclosure
FIG. 8 is a schematic diagram showing a perspective structure of a plastic packaged semiconductor power module according to an embodiment of the present disclosure;
FIG. 9 is a side view of a semiconductor power module according to an embodiment of the present disclosure;
FIG. 10 is a schematic view of a semiconductor power module according to another embodiment of the present disclosure;
FIG. 11 is a schematic view showing a structure of a motor controller according to an embodiment of the present disclosure;
FIG. 12 is a block diagram showing a structure of a vehicle according to an embodiment of the present disclosure.

### Reference numerals:

Vehicle 100;
Semiconductor power module 10; Motor controller 20;
Substrate 1; First conductive region 2; Second conductive region 3; Third conductive region 4; Fourth conductive region 5; First direct current connection point 11; Second direct current connection point 12; Third direct current connection point 13; Alternating current connection point 14; First power chip 6; Second power chip 7; Third power chip 8; Lead 15; Copper sheet 16; First conductive portion 21 of the first conductive region; Second conductive portion 22 of the first conductive region; Third conductive portion 23 of the first conductive region; First conductive portion 31 of the second conductive region; Second conductive portion 32 of the second conductive region; Third conductive portion 33 of the second conductive region; First converging conductive portion 41; First conductive branch 42; Second converging conductive portion 51; Second conductive branch 52; First edge 101; Second edge 102; Third edge 103; Fourth edge 104;
Coolant liquid channel 17; Heat-dissipating base plate 18; Motor 19.

### DESCRIPTION OF EMBODIMENTS

Embodiments of the present disclosure will be described hereinafter in detail. Examples of the embodiments are illustrated in the drawings, throughout which the same or similar reference numerals refer to the same or similar elements or elements having the same or similar functions. The embodiments described below with reference to the accompanying drawings are illustrative to explain the present disclosure and should not be construed as being limited to the present disclosure.

In the description of the present disclosure, it should be understood that terms "center", "length", "width", "thickness", "upper", "lower", "front", "back", "left", "right", "top", "bottom", "inside", "outside", "clockwise", "counterclockwise", "axial", "radial", "circumferential" and the like refer to orientation or positional relationship based on the orientation or positional relationship shown in the drawings. Those merely intend to describe the present disclosure and simplify description, and do not indicate or imply that the indicated devices or components must be constructed and operated in a particular orientation. Therefore, the above cannot be construed as being limited to the present disclosure.

In the description of the present disclosure, features defining "first" and "second" may explicitly or implicitly include one or more features. In the description of the present disclosure, "plurality" means two or more, unless otherwise stated.

The present disclosure proposes a semiconductor power module, by which the inductance of the entire semiconductor power module can be reduced and the heat-dissipation of the semiconductor power module can be improved.

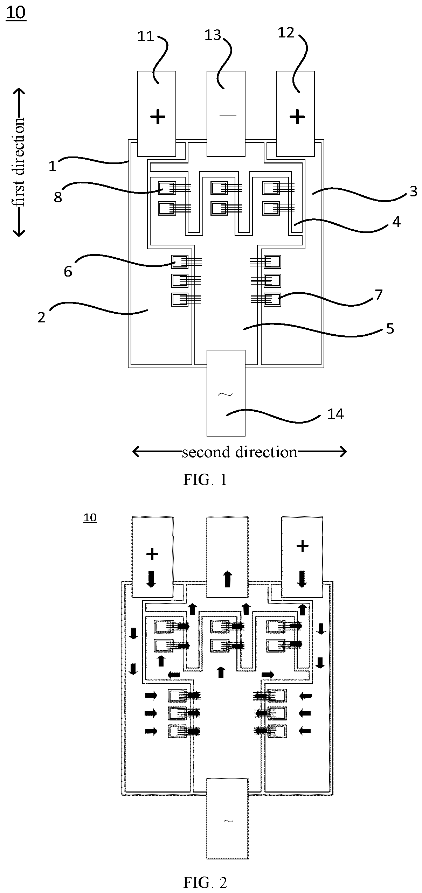

The semiconductor power module proposed in the present disclosure is described below with reference to FIG. 1 to FIG. 8.

As shown in FIG. 1, the semiconductor power module 10 includes a substrate 1 and a first conductive region 2, a second conductive region 3, a third conductive region 4, and a fourth conductive region 5 that are disposed on the substrate 1, and at least a first power chip 6, at least a second power chip 7, and at least a third power chip 8.

In the embodiment, the substrate 1 may be an insulating substrate with high insulating strength, good thermal conductivity, and stable chemical properties, such as an insulating ceramic, for example, Al₂O₃, AlN, or Si₃N₄, etc. Thus, the setup of the insulating substrate 1 can not only block the electrical connection between a circuit and an external device, such as a heatsink, but also provide a heat-dissipation channel for the loss caused by the subsequent power chip operation, and improve the overall heat-dissipation of the module.

The substrate 1 has a first direction and a second direction that are orthogonal to each other, that is, if the first direction is a length direction of the substrate 1, the second direction is a width direction of the substrate 1; or if the first direction is the width direction of the substrate 1, the second direction is the length direction of the substrate 1. In this regard, the first direction and the second direction can be set according to the actual situation, such as the shape of the substrate 1, and there is no limitation thereon.

In addition, as shown in FIG. 1, the first conductive region 2, the second conductive region 3, the third conductive region 4, and the fourth conductive region 5 are spaced apart from each other to avoid short-circuiting caused by overlapping of these conductive regions. The first conductive region 2 and the second conductive region 3 extend along the first direction of the substrate 1 and are arranged along the second direction of the substrate 1, the third conductive region 4 and the fourth conductive region 5 are located between the first conductive region 2 and the second conductive region 3 and are arranged along the first direction. The first conductive region 2, the second conductive region 3, and the third conductive region 4 are configured to transmit a direct current signal, and the fourth conductive region 5 is configured to transmit an alternating current signal to realize the electrical energy conversion function of the semiconductor power module 10.

A copper layer is attached to each of both sides of the insulating substrate 1 by printing process, and each conductive region is set as a copper layer, so that a three-layer substrate can be formed between the insulating substrate 1 and these conductive regions, that is, copper layer-ceramic layer-copper layer. Therefore, the back side of the substrate, that is, the side of the substrate 1 away from these conductive regions is the whole sheet of bare copper, the front side of the substrate, that is, the side of the substrate where these conductive regions are located is an etched copper layer. The etched copper layer forms a conductive channel, which forms a half-bridge circuit of the semiconductor power module 10 after being electrically connected. Specifically, referring to FIG. 2, the first power chip 6 is electrically connected to each of the first conductive region 2 and the fourth conductive region 5, the second power chip 7 is electrically connected to each of the second conductive region 3 and the fourth conductive region 5, and the third power chip 8 is electrically connected to each of the fourth conductive region 5 and the third conductive region 4. The first power chip 6, the second power chip 7, the first conductive region 2, the second conductive region 3, the fourth conductive region 5 are electrically connected to form a first bridge arm of the half-bridge circuit. The third power chip 8, the fourth conductive region 5 and the third conductive region 4 are electrically connected to form a second bridge arm of the half-bridge circuit. Mutual inductance is formed between the first bridge arm and the second bridge arm so as to reduce the parasitic inductance of the entire module. At the same time, because the first conductive region 2, the second conductive region 3, the third conductive region 4, and the fourth conductive region 5 are arranged along the substrate 1, it is also convenient to arrange the first power chip 6, the second power chip 7, and the third power chip 8 uniformly in the three conductive regions, avoiding the situation where the power chips are arranged in a compact manner, and thus facilitating the reduction of the inductance while increasing heat-dissipation, and improving the current output capability.

In an embodiment, the power chip may use silicon or silicon carbide or other semiconductor materials as the substrate. For example, the power chip may use silicon carbide Metal-Oxide-Semiconductor Field-Effect Transistor (MOSFET), or may use a device obtained by cooperation of Insulated Gate Bipolar Transistor (IGBT) and Fast Recovery Diode (FRD). The power chip is not limited to any of the examples.

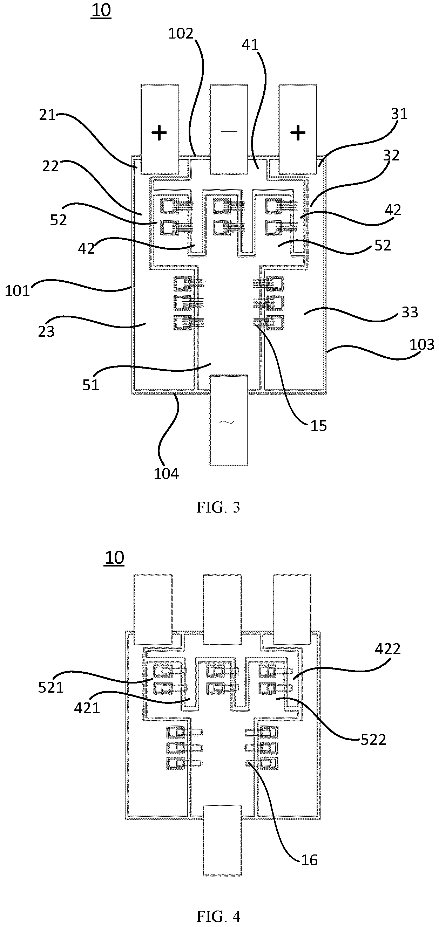

Under the premise of realizing an electrical connection between the power chip and different conductive regions, there is no restriction on the arrangement of the power chip and the different conductive regions. For example, the power chip can be fixed in a corresponding conductive region by welding attachment or bonding attachment. In addition, each power chip can be electrically connected between different conductive regions via leads. For example, as shown in FIG. 3, the second power chip 7 of the second conductive region 3 is connected to the fourth conductive region 5 through the lead 15. Alternatively, each power chip can be electrically connected between different conductive regions via copper sheet bonding. For example, as shown in FIG. 4, the second power chip 7 of the second conductive region 3 is connected to the fourth conductive region 5 through a copper sheet 16.

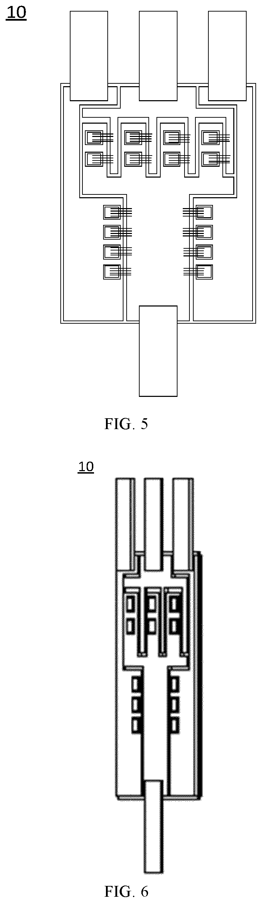

The number of the first power chip 6, the second power chip 7 and the third power chip 8 can be set according to the actual needs, there is no limitation on this. For example, in the semiconductor power module 10 shown in FIG. 1, the number of the first power chips 6 is 3, the number of the second power chips 7 is 3, and the number of the third power chips 8 is 6. Considering the need to output a large current, the number of these power chips can be increased. As shown in FIG. 5, the number of first power chips 6 in the semiconductor power module 10 is 4, the number of second power chips 7 is 4, and the number of third power chips 8 is 8.

In an embodiment, the first conductive region 2, the second conductive region 3, the third conductive region 4 and the fourth conductive region 5 each can be designed as a conductive region having a regular shape, such as a square conductive region. Alternatively, the first conductive region 2, the second conductive region 3, the third conductive region 4 and the fourth conductive region 5 each can be designed as a conductive region having an irregular shape. For example, each two of these conductive regions are staggered or match each other, and the present application is not limited thereto. In addition, the design positions of the first power chip 6, the second power chip 7, and the third power chip 8, without changing the function of the semiconductor power module 10, can be adjusted based on changes in the shapes of the conductive regions, for example can be adjusted to be rotated by 90 degrees to the left or to the right, and the present application is not limited thereto.

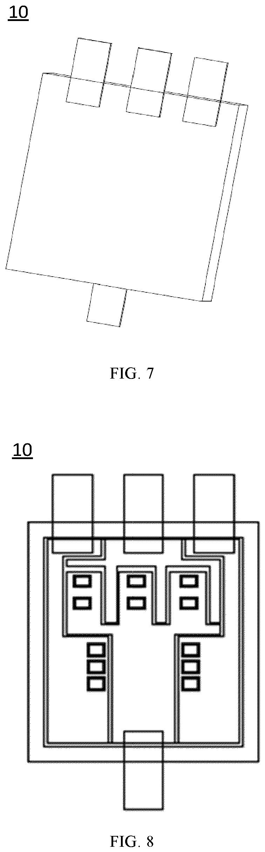

In an embodiment, the semiconductor power module 10 needs to be packaged in practical application. For example, the semiconductor power module 10 can be packaged by the plastic package method. That is, a semi-finished product of the semiconductor power module 10 can be packaged by injection moulding. Specifically, all the structures in the semiconductor power module 10 shown in FIG. 6 are mounted in a frame and are subject to plastic package to form a plastic packaged body module, such as the plastic packaged semiconductor power module 10 as shown in FIG. 7, FIG. 8 and FIG. 9. Alternatively, a potting method may be used, that is, a semi-finished product of the semiconductor power module 10 is subject to a potting forming process in which an insulating material such as silicone gel is used. Specifically, all of the structures in the semiconductor power module 10 shown in FIG. 5 are mounted in a frame, and the silicone gel is filled into the frame to form a potted module. It should be noted that the semiconductor power module 10 is a half-bridge power module which can be applied to a half-bridge circuit or a three-phase full-bridge circuit. Here, for the plastic package method, a single semiconductor power module 10 forms one plastic package body, that is, one half-bridge circuit forms one plastic package body. For the potting method, a single semiconductor power module 10 can forms a potted body, that is, one half-bridge circuit forms a potted body, or three semiconductor power modules can form one potted body, that is, a three-phase full-bridge circuit composed of three half-bridge circuits forms a potted body.

According to the semiconductor power module 10 of the present disclosure, based on the layout design of the first conductive region 2, the second conductive region 3, the third conductive region 4 and the fourth conductive region 5, the first power chip 6 is electrically connected to each of the first conductive region 2 and the fourth conductive region 5, the second power chip 7 is electrically connected to each of the second conductive region 3 and the fourth conductive region 5, and the third power chip 8 is electrically connected to each of the fourth conductive region 5 and the third conductive region 4. Thereby, after the circuit is connected, the first power chip 6 and the second power chip 7 are correspondingly electrically connected to the first conductive region 2, the second conductive region 3 and the fourth conductive region 5, so as to form a first bridge arm of a half-bridge circuit. The third power chip 8 is electrically connected to the fourth conductive region 5 and the third conductive region 4 to form a second bridge arm of the half-bridge circuit. Mutual inductance is formed between the first bridge arm and the second bridge arm to thereby reduce the parasitic inductance of the entire module. In addition, based on the layout design of the first conductive region 2, the second conductive region 3, the third conductive region 4, and the fourth conductive region 5, some first power chips 6, some second power chips 7, and some third power chips 8 are uniformly arranged in the three conductive regions, with good heat-dissipation performance, simple structure, and a high integration degree. Furthermore, the use of the substrate 1 can also provide a heat-dissipation channel for the loss caused by the power chip operation, and improve the overall heat-dissipation of the module.

In some embodiments, when the semiconductor power module is used as an electronic controller, the first conductive region 2, the second conductive region 3 and the third conductive region 4 are configured to receive a direct current signal, and the fourth conductive region 5 is configured to output an alternating current signal. In this way, the semiconductor power module can effectively realize the control of an electronic device connected thereto.

In some other embodiments, when the semiconductor power module is used as a charger, the fourth conductive region 5 is configured to receive an alternating current signal, and the first conductive region 2, the second conductive region 3 and the third conductive region 4 are configured to output a direct current signal.

In some embodiments, as shown in FIG. 3, the substrate 1 has a first edge 101, a second edge 102, a third edge 103, and a fourth edge 104 that are connected in a sequential and head to tail manner. The first edge 101 and the third edge 103 are disposed opposite to each other in the second direction, and the second edge 102 and the fourth edge 104 are disposed opposite to each other in the first direction. The first conductive region 2 is disposed adjacent to each of the first edge 101, the second edge 102, and the fourth edge 104, the second conductive region 3 is disposed adjacent to each of the third edge 103, the second edge 102, and the fourth edge 104. The third conductive region 4 is disposed adjacent to the second edge 102. The fourth conductive region 5 is disposed adjacent to the fourth edge 104. Therefore, the structural layout inside the semiconductor power module 10 can be optimized, which is conducive to improving the integration degree of the entire module.

In some embodiments, as shown in FIG. 1, the third conductive region 4 extends between the first conductive region 2 and the second conductive region 3 along the second direction and is disposed adjacent to one end of the first conductive region 2 and one end of the second conductive region 3 that receive the direct current signal. In this way, it facilitates the realization of receiving the direct current signals at the same edge of the substrate 1 in later time when receiving the direct current signal, which is conducive to reducing the processing difficulty during the encapsulation. The fourth conductive region 5 extends between the first conductive region 2 and the second conductive region 3 along the first direction, and is disposed adjacent to another end of the first conductive region 2 and another end of the second conductive region 3. In this way, the structural layout inside the semiconductor power module 10 can be optimized, which is conducive to improving the integration degree of the entire module.

In some embodiments, as shown in FIG. 3, the first conductive region 2 has a first conductive portion 21, a second conductive portion 22, and a third conductive portion 23 that are connected in sequence along the first direction, the first conductive portion 21 of the first conductive region 2 is configured to receive the direct current signal, and the third conductive portion 23 of the first conductive region 2 protrudes, in comparison to the second conductive portion 22, towards the fourth conductive region 5. In addition, the second conductive region 3 has a first conductive portion 31, a second conductive portion 32, and a third conductive portion 33 that are connected in sequence along the first direction, the first conductive portion 31 of the second conductive region 3 is configured to receive the direct current signal, and the third conductive portion 33 of the second conductive region 3 protrudes, in comparison to the second conductive portion 32, towards the fourth conductive region 5.

In addition, as shown in FIG. 3, the first power chip 6 is connected to the third conductive portion 23 of the first conductive region 2, the second power chip 4 is connected to the third conductive portion 33 of the second conductive region 3, and the third power chip 8 is located among the first conductive portion 21 of the first conductive region 2, the second conductive portion 22 of the first conductive region 2, the first conductive portion 31 of the second conductive region 3, and the second conductive portion 32 of the second conductive region 3 in the first direction. This arrangement can not only optimize the structural layout inside the semiconductor power module 10, which is conducive to improving the integration degree of the entire module, but also make the first power chip 6, the second power chip 7, and the third power chip 8 staggered, which improves the heat-dissipation of the module.

In some embodiments, as shown in FIG. 3, an edge of the second conductive portion 22 of the first conductive region 2 that faces away from the third conductive region 4 is flush with an edge of the third conductive portion 23 of the first conductive region 2 that faces away from the fourth conductive region 5, and the third conductive portion 23 of the first conductive region 2 has a width that is greater than a width of the second conductive portion 22 of the first conductive region 2. In this way, the third conductive portion 23 of the first conductive region 2 protrudes, in comparison to the second conductive portion 22, towards the fourth conductive region 5. An edge of the second conductive portion 32 of the second conductive region 3 that faces away from the third conductive region 4 is flush with an edge of the third conductive portion 33 of the second conductive region 3 that faces away from the fourth conductive region 5, and the third conductive portion 33 of the second conductive region 3 has a width that is greater than a width of the second conductive portion 32 of the second conductive region 3. In this way, the the third conductive portion 33 of the second conductive region 3 protrudes, in comparison to the second conductive portion 32, towards the fourth conductive region 5. In this design, sufficient space be reserved among the first conductive portion 21 of the first conductive region 2, the second conductive portion 22 of the first conductive region 2, the first conductive portion 31 of the second conductive region 3, and the second conductive portion 32 of the second conductive region 3 so as to arrange the third power chip 8, which is conducive to optimizing the structural layout inside the semiconductor power module 10 and improving the integration degree of the entire module.

In some embodiments, as shown in FIG. 3, an edge of the first conductive portion 21 of the first conductive region 2 that faces away from the third conductive region 4 is flush with an edge of the second conductive portion 22 of the first conductive region 2 that faces away from the fourth conductive region 5, and the first conductive portion 21 of the first conductive region 2 has a width that is greater than a width of the second conductive portion 22 of the first conductive region 2. In this way, the first conductive portion 21 of the first conductive region 2 protrudes, in comparison to the second conductive portion 22, towards the third conductive region 4. An edge of the first conductive portion 31 of the second conductive region 3 that faces away from the third conductive region 4 is flush with an edge of the second conductive portion 32 of the second conductive region 3 that faces away from the fourth conductive region 5, and the first conductive portion 31 of the second conductive region 3 has a width that is greater than a width of the second conductive portion 32 of the second conductive region 3. In this way, the first conductive portion 31 of the second conductive region 3 protrudes, in comparison to the second conductive portion 32, towards the fourth conductive region 5.

In some embodiments, as shown in FIG. 3, the third conductive region 4 includes a first converging conductive portion 41 and a plurality of first conductive branches 42.

Here, the first converging conductive portion 41 extends in the second direction and is configured to receive the direct current signal, and the first conductive branch 42 is connected with the first converging conductive portion 41 and extends towards the fourth conductive region 5 in the first direction. The first conductive branch 42 is located between the second conductive portion 22 of the first conductive region 2 and the second conductive portion 32 of the second conductive region 3, and the third power chip 8 is connected to the first conductive branch 42 of the third conductive region 4. Thus, based on the design of the first conductive branch 42, the third power chips can be evenly arranged at each of the first conductive branches 42 correspondingly. In this way, it not only can form a mutual inductance within the semiconductor power module 10 when it is operating, effectively reduce the parasitic inductance of the entire module, but also can optimize the internal structural layout of the semiconductor power module 10, which is conducive to improving the integration degree of the entire module, avoiding the problem of increased heat due to the compact layout of the power chip, improving the heat-dissipation of the module.

In some embodiments, as shown in FIG. 3, the fourth conductive region 5 includes a second converging conductive portion 51 and a plurality of second conductive branches 52.

Herein, the second converging conductive portion 51 extends in the first direction and is configured to output the alternating current signal. The second conductive branch 52 is connected with the second converging conductive portion 51 and extends towards the third conductive region 4 in the first direction. The second converging conductive portion 51 is located between the third conductive portion 23 of the first conductive region 2 and the third conductive portion 33 of the second conductive region 3, the first power chip 6 and the second power chip 7 are connected to the second converging conductive portion 51 of the fourth conductive region 5, the second conductive branch 52 is located between the second conductive portion 22 of the first conductive region 2 and the second conductive portion 32 of the second conductive region 3, the third power chip 8 is connected to the second conductive branch 52 of the fourth conductive region 5. Thus, it not only can form a mutual inductance within the semiconductor power module 10 when it is operating, effectively reduces the parasitic inductance of the entire module, but also can optimize the internal structural layout of the semiconductor power module 10, which is conducive to improving the integration degree of the entire module and avoiding the problem of increased heat due to the compact layout of the power chip, and improving the heat-dissipation of the module.

In some embodiments, the plurality of the first conductive branches 42 and the plurality of the second conductive branches 52 are arranged alternately along the second direction, and the first conductive branch 42 and the second conductive branch 52 that are adjacent to each other are connected through the third power chip 8. As a result, through the alternate arrangement of the first conductive branches 42 and the second conductive branches, it is convenient to evenly arrange the plurality of third power chips 8 at the corresponding conductive branches, thereby avoiding the problem of compact arrangement of the power chips and improving the heat-dissipation of the module. At the same time, based on the first conductive branches 42 and the second conductive branches cooperating with each other, in a case in which the number of power chips is increased, it only needs to increase the number of the conductive branches, the structure design is simple, is easy to realize, and will not cause the problem of increasing heat.

In some embodiments, the first conductive branch 42 and the second conductive branch 52 that are adjacent to each other are connected by a plurality of third power chips 8 that are spaced apart along the first direction, the third power chips 8 on the two outermost sides in the second direction are same in quantity. For example, as shown in FIG. 4, when the third power chips 8 are provided in the first conductive branch 42, the first conductive branches 42 arranged at the two outermost sides in the second direction are the first conductive branch 421 and the first conductive branch 422 respectively, and when the third power chips 8 are arranged, the number of the third power chips 8 on the first conductive branch 421 and the number of the third power chips 8 on the first conductive branch 422 are equal. Alternatively, when the third power chips 8 are provided in the second conductive branch 52, the second conductive branches 52 arranged at the two outermost sides in the second direction are the second conductive branch 521 and the second conductive branch 522 respectively, and when the third power chips 8 are arranged, the number of the third power chips 8 on the second conductive branch 521 and the number of the third power chips 8 on the second conductive branch 522 are equal. As a result, the current balance in the half-bridge circuit of the semiconductor power module 10 can be ensured, and the parasitic inductance of the entire module can be reduced.

It is to be noted that, except the first conductive branch 421 and the first conductive branch 422 in the plurality of the first conductive branches 42, there is no limitation on the number of the third power chip(s) 8 provided on the other first conductive branch(es) 42. Alternatively, except the second conductive branch 521 and the second conductive branch 522 in the plurality of the second conductive branches 52, there is no limitation on the number of the third power chip(s) 8 provided on the other second conductive branch(es) 52. In addition, there is no limitation on the arrangement manner of the third power chips 8 provided on each second conductive branch 52 or each first conductive branch 42. For example, the third power chips 8 on each second conductive branch 52 or each first conductive branch 42 are symmetrically arranged or staggered. Preferably, each second conductive branch 52 or each first conductive branch 42 is provided with the same number of the third power chips 8 that are arranged in one-one correspondence. For example, as shown in FIG. 3, each second conductive branch 52 is provided thereon with two third power chips 8 that are arranged in the first direction, and the third power chips 8 are provided on the corresponding second conductive branches 52 in an array of two rows and three columns.

In some embodiments, the first conductive region 2, the second conductive region 3, and the third conductive region 4 each have a direct current connection point for receiving the direct current signal, and the fourth conductive region 5 has an alternating current connection point for outputting the alternating current electrical signal. In practical applications, for the semiconductor power module 10, direct current terminals are used to be respectively electrically connected to the direct current connection points of the corresponding conductive regions, and an alternating current terminal is used to be electrically connected to the alternating current connection point of the fourth conductive region 5, so as to realize the connection between the semiconductor power module 10 and the outside through the direct current terminals and the alternating current terminal, so as to receive the direct current signal sent from the outside and to output the alternating current signal to the outside, thereby realizing the function of electric energy conversion.

The setting position of each direct current connection point in the corresponding conductive region can be set according to the actual situation, such as the shape of each conductive region. For example, all direct current connection points can be set on any side of the substrate 1, or each direct current connection point can be set arbitrarily, such as respectively set in the different sides of the substrate 1, and the present application is not limited thereto. Similarly, the setting position of the alternating current connection point in the fourth conductive region can be set based on the actual situation, and there is no restriction thereon.

It is to be understood that, in practical applications, the direct current terminal that is configured to be connected to the direct current connection point and the alternating current terminal that is configured to be connected to the alternating current connection point both are made of copper material with good electrical and thermal conductivity, so as to realize the connection between the semiconductor power module 10 and the external devices.

In some embodiments, as shown in FIG. 1, the first conductive region 2 has a first direct current connection point 11 for receiving the direct current signal, the second conductive region 3 has a second direct current connection point 12 for receiving the direct current signal, the third conductive region 4 has a third direct current connection point 13 for receiving the direct current signal, and the fourth conductive region 5 has an alternating current connection point 14. The first direct current connection point 11, the second direct current connection point 12 and the third direct current connection point 13 are disposed on one side of the substrate 1 in the first direction and are arranged in the second direction, the third direct current connection point 13 is disposed between the first direct current connection point 11 and the second direct current connection point 12, the alternating current connection point 14 is located on the other side of the substrate 1 in the first direction. For example, as shown in FIG. 1, the first direct current connection point 11, the second direct current connection point 12 and the third direct current connection point 13 are disposed on the first edge of the substrate 1, and the alternating current connection point 14 is disposed on the fourth edge 104 of the substrate 1. Thus, by the above design, the direct current signal can be introduced on the same side of the substrate 1, which can effectively reduce the difficulty of the subsequent process compared to the design in which the direct current connection points are not provided on the same side.

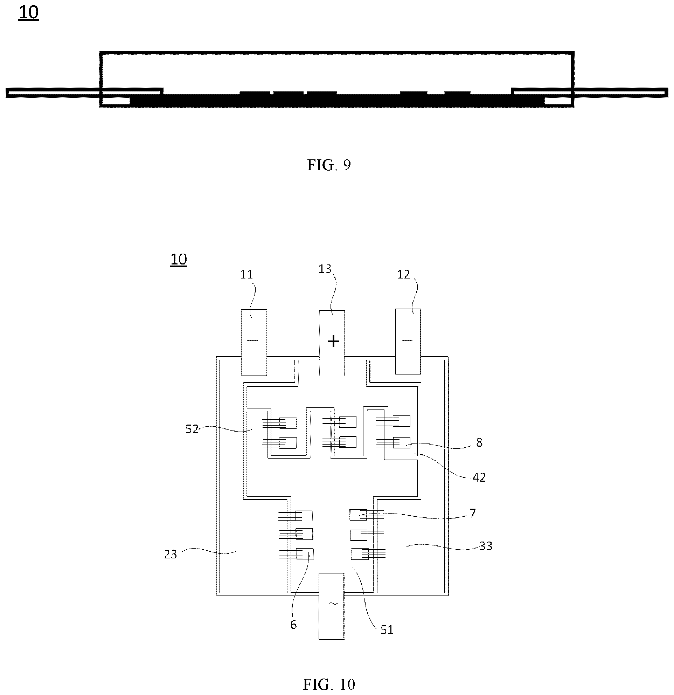

A polarity of the direct current signal connected to the first direct current connection point 11 is the same as a polarity of the direct current signal connected to the second direct current connection point 12, and a polarity of the direct current signal connected to the third direct current connection point 13 is opposite to the polarity of the direct current signal connected to the first direct current connection point 11. That is, if the direct current signals connected respectively to the first direct current connection point 11 and the second direct current connection point 12 are anodic, the direct current signal connected to the third direct current connection point 13 is cathodic, as shown in FIG. 1. Alternatively, if the direct current signals connected to the first direct current connection point 11 and the second direct current connection point 12 are cathodic, the direct current signal connected to the third direct current connection point 13 is anodic, as shown in FIG. 10.

In some embodiments, when the first direct current connection point 11 and the second direct current connection point 12 are anodic direct current connection points and the third direct current connection point 13 is a cathode direct current connection point, the first power chip 6 is provided in the first conductive region 2 and is electrically connected to the fourth conductive region 5, the second power chip 7 is provided in the second conductive region 3 and is electrically connected to the fourth conductive region 5, and the third power chip 8 is provided in the fourth conductive region 5 and is electrically connected to the third conductive region 4. For example, as shown in FIG. 1, the first power chip 6 is provided at the third conductive portion 23 of the first conductive region 2 and is electrically connected to the second converging conductive portion 51 of the fourth conductive region 5, the second power chip 7 is provided at the third conductive portion 33 of the second conductive region 3 and is electrically connected to the second converging conductive portion 51 of the fourth conductive region 5, and the third power chip 8 is provided at the second conductive branch 52 of the fourth conductive region 5 and is electrically connected to the first conductive branch 42 of the third conductive region 4.

Specifically, taking FIG. 1 as an example, in practice, the first direct current connection point 11 of the first conductive region 2 is connected to an anode terminal, the second direct current connection point 12 of the second conductive region 3 is connected to an anode terminal, the third direct current connection point 13 of the third conductive region 4 is connected to a cathode terminal, and the alternating current connection point 14 of the fourth conductive region 5 is connected to an alternating current terminal. Specifically, referring to FIG. 2, the first direct current connection point 11 and the second direct current connection point 12 are high-potential direct current terminals, the third direct current connection point 13 is a low-potential direct current terminal, the first direct current connection point 11, the second direct current connection point 12, and the third direct current connection point 13 are arranged on the same side of the substrate 1, and the alternating current connection point 14 is arranged opposite to the above mentioned three direct current connection points. As a result, after the half-bridge circuit of the semiconductor power module 10 is connected, the high-potential direct current terminal is connected to the alternating current connection point 14 to form a first bridge arm of the half-bridge circuit, and the alternating current connection point 14 is connected to the low-potential direct current terminal to form a second bridge arm of the half-bridge circuit, so that the mutual inductance is formed between the circuit formed by the first bridge arm and the circuit formed by the second bridge arm in the semiconductor power module 10, and therefore the parasitic inductance of the entire module can be reduced.

In some embodiments, when the first direct current connection point 11 and the second direct current connection point 12 are cathode direct current connection points and the third direct current connection point 13 is an anode direct current connection point, the first power chip 6 is provided in the fourth conductive region 5 and is electrically connected to the first conductive region 2, the second power chip 7 is provided in the fourth conductive region 5 and is electrically connected to the second conductive region 3, and the third power chip 8 is provided in the third conductive region 4 and is electrically connected to the fourth conductive region 5. For example, as shown in FIG. 10, the first power chip 6 is provided at the second converging conductive portion 51 of the fourth conductive region 5 and is electrically connected to the third conductive portion 23 of the first conductive region 2, the second power chip 7 is provided at the second converging conductive portion 51 of the fourth conductive region 5 and is electrically connected to the third conductive portion 33 of the second conductive region 3, and the third power chip 8 is provided at the first conductive branch 42 of the third conductive region 4 and is electrically connected to the second conductive branch 52 of the fourth conductive region 5.

Specifically, in practice, the first direct current connection point 11 of the first conductive region 2 is connected to a cathode terminal, the second direct current connection point 12 of the second conductive region 3 is connected to the cathode terminal, the third direct current connection point 13 of the third conductive region 4 is connected to an anode terminal, and the alternating current connection point 14 of the fourth conductive region 5 is connected to the alternating current terminal. Specifically, referring to FIG. 10, the first direct current connection point 11 and the second direct current connection point 12 are low-potential direct current terminals, the third direct current connection point 13 is a high-potential direct current terminal. The first direct current connection point 11, the second direct current connection point 12, and the third direct current connection point 13 are arranged on the same side of the substrate 1, and the alternating current connection point 14 is arranged opposite to the above mentioned three direct current connection points. As a result, after the half-bridge circuit of the semiconductor power module 10 is connected, the high-potential direct current terminal is connected to the alternating current connection point 14 to form a first bridge arm of the half-bridge circuit, and the alternating current connection point 14 is connected to the low-potential direct current terminal to form a second bridge arm of the half-bridge circuit. Therefore, the mutual inductance is formed between the circuit formed by the first bridge arm and the circuit formed by the second bridge arm in the semiconductor power module 10, and the parasitic inductance of the entire module can be reduced thereby.

In some embodiments, a sum of the number of the at least one first power chip 6 and the number of the at least one second power chip 7 is equal to the number of the at least one third power chip 8, thereby avoiding the problem of current imbalance in the half-bridge circuit.

In some embodiments, a plurality of third power chips 8 are included and the plurality of the third power chips 8 are arranged in the first direction or the second direction. For example, FIG. 1 shows that the plurality of third power chips 8 arranged in the first direction.

In some embodiments, the first power chip 6 and the second power chip 7 are arranged in the second direction. As shown in FIG. 1, along the second direction of the substrate 1, the first power chip 6 is disposed on one side of the fourth conductive region 5 that is disposed adjacent to the first conductive region 2, and the second power chip 7 is disposed on one side of the fourth conductive region 5 that is disposed adjacent to the second conductive region 3. A plurality of first power chips 6 are included, a plurality of second power chips 7 are included, and the plurality of the first power chips 6 are arranged in the same direction as that of the plurality of the second power chips 7. As shown in FIG. 1, the plurality of the first power chips 6 are arranged in the first direction along the substrate 1, and the plurality of the second power chips 7 are arranged in the first direction along the substrate 1. Therefore, the first power chip 6 and the second power chip 7 are spaced apart in the second direction, so that the first power chip 6 and the second power chip 7 are connected in parallel in the second direction and are connected in series with the third power chip 8 in the first direction, so as to form a half-bridge circuit of the semiconductor power module 10, reduce the parasitic inductance of the entire module, and at the same time, avoid the problem of increasing heat due to the compact layout of the power chips.

In some embodiments, the first power chip 6 and the third power chip 8 are arranged along the first direction, and the second power chip 7 and the third power chip 8 are arranged along the first direction. As a result, the first power chip 6, the second power chip 7, and the third power chip 8 can be staggered to avoid the problem of the compact layout of the power chips, so that the heat-dissipation of the module can be further improved while reducing the inductance.

In some embodiments, as shown in FIG. 1, the first conductive region 2 is connected to the fourth conductive region 5 via a plurality of the first power chips 6 that are spaced apart in the first direction, the second conductive region 3 is connected to the fourth conductive region 5 via a plurality of the second power chips 7 that are spaced apart in the first direction, and the plurality of the first power chips 6 and the plurality of the second power chips 7 are disposed in one-to-one correspondence in the second direction. In this way, it can optimize the internal structural layout of the semiconductor power module 10 and to improve the integration of the module.

In some embodiments, the semiconductor power module 10 further includes an insulating cover body mounted on the substrate 1 and covering the first conductive region 2, the second conductive region 3, the third conductive region 4, the fourth conductive region 5, the at least one first power chip 6, the at least one second power chip 7 and the at least one third power chip 8 to insulate and protect elements therein.

In conclusion, the semiconductor power module 10 according to the present disclosure has the advantages of high integration, good heat-dissipation performance, and simple structure.

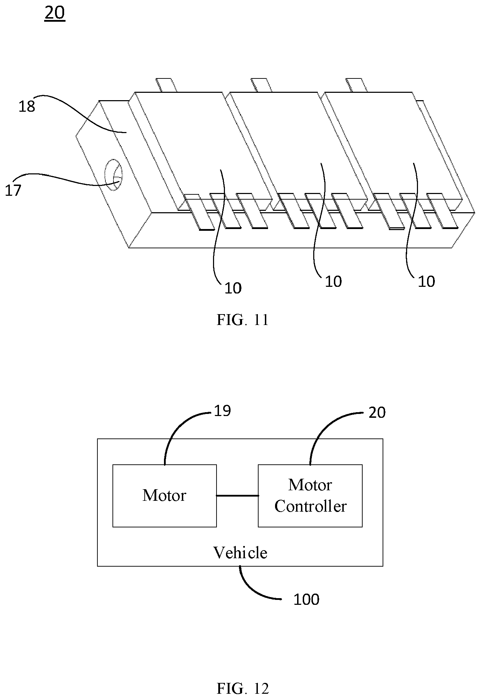

According to an embodiment of the second aspect of the present disclosure, a motor controller is provided. As shown in FIG. 11, the motor controller 20 includes a heat-dissipating base plate 18, a cooling liquid channel 17 and a semiconductor power module 10 provided in the any of the above embodiments.

The heat-dissipating base plate 18 is mounted to the cooling liquid channel 17, and the at least one semiconductor power module 10 is disposed on the heat-dissipating base plate 18.

For example, as shown in FIG. 11, three semiconductor power modules 10 arranged in parallel are arranged in a linear pattern, and the heat-dissipating base plate 18 is welded to the bottom of the semiconductor power modules 10, and the cooling liquid channel 17 such as a water channel is provided with slots such as a watercourse, and the heat-dissipation base plate 18 is mounted on the slots of the coolant liquid channel 17, so as to cool the semiconductor power module 10, In this way, the motor controller is simple in design, is easy to realize, and is convenient to operate.

In the embodiment, the semiconductor power module 10 based on the above embodiment has a uniform structural layout and good heat-dissipation, and the motor controller 20 can be applied to the application of various coolant channels, such as series coolant channels or parallel coolant channels, which can improve the flexibility of the application of the motor controller 20, and reduce the stray inductance in the circuit during the application.

The motor controller 20 according to the present disclosure, by adopting the semiconductor power module 10 that is provided in the above embodiment and that is provided on the heat-dissipation base plate 18, the stray inductance in the circuit can be effectively reduced and the heat-dissipation is good.

According to an embodiment of a third aspect of the present disclosure, a vehicle is provided. As shown in FIG. 12, the vehicle 100 includes a motor 19 and a motor controller 20 provided in any of the above embodiments, the motor controller 20 is connected to the motor 19.

According to the vehicle 100 of the present disclosure, by using the motor controller 20 provided in the above embodiment, the inductance can be reduced and heat-dissipation can be improved.

In the illustration of this description, an illustration with reference to the terms "one embodiment", "some embodiments", "illustrative embodiments", "an example", "a particular example" or "some examples" and so on mean that a particular feature, structure, material, or characteristic described in connection with the embodiment(s) or example(s) is included in at least one embodiment or example of the present disclosure. In this description, the exemplary expressions of the above terms do not necessarily specify the same embodiments or examples.

Although embodiments of the present disclosure have been shown and described, it will be understood by those skilled in the art that various changes, modifications, alternations and modifications may be made to these embodiments without departing from the principles and spirit of the present disclosure, the scope of which is defined by the claims and their equivalents.

## Claims

1. A semiconductor power module, comprising:
A substrate (1) having a first direction and a second direction that are orthogonal to each other;
a first conductive region (2), a second conductive region (3), a third conductive region (4), and a fourth conductive region (5) that are disposed on the substrate and that are spaced apart from each other, wherein the first conductive region and the second conductive region extend along the first direction of the substrate and are arranged along the second direction of the substrate, the third conductive region and the fourth conductive region are located between the first conductive region and the second conductive region and are arranged along the first direction, the first conductive region, the second conductive region and the third conductive region are configured to transmit a direct current signal, and the fourth conductive region is configured to transmit an alternating current signal; and
at least one first power chip (6), at least one second power chip (7), and at least one third power chip (8), the first power chip is electrically connected to each of the first conductive region and the fourth conductive region, the second power chip is electrically connected to each of the second conductive region and the fourth conductive region, and the third power chip is electrically connected to each of the fourth conductive region and the third conductive region.

2. The semiconductor power module according to claim 1, wherein the first conductive region, the second conductive region, and the third conductive region are configured to receive the direct current signal, and the fourth conductive region is configured to output the alternating current signal.

3. The semiconductor power module according to claim 1 or 2, wherein the substrate has a first edge (101), a second edge (102), a third edge (103), and a fourth edge (104) that are connected in a sequential and head to tail manner, the first edge and the third edge are disposed opposite to each other in the second direction, and the second edge and the fourth edge are disposed opposite to each other in the first direction; and
wherein the first conductive region is disposed adjacent to each of the first edge, the second edge, and the fourth edge, the second conductive region is disposed adjacent to each of the third edge, the second edge and the fourth edge, the third conductive region is disposed adjacent to the second edge, and the fourth conductive region is disposed adjacent to the fourth edge.

4. The semiconductor power module according to claim 2 or 3, wherein the third conductive region extends between the first conductive region and the second conductive region along the second direction and is disposed adjacent to one end of the first conductive region and one end of the second conductive region that receive the direct current signal; and
the fourth conductive region extends between the first conductive region and the second conductive region along the first direction and is disposed adjacent to another end of the first conductive region and another end of the second conductive region.

5. The semiconductor power module according to any of claims 2 to 4, wherein each of the first conductive region and the second conductive region comprises:
a first conductive portion, a second conductive portion, and a third conductive portion that are connected in sequence along the first direction, wherein the first conductive portion is configured to receive the direct current signal, the third conductive portion protrudes, in comparison to the second conductive portion, towards the fourth conductive region, the first power chip is connected to the third conductive portion of the first conductive region, the second power chip is connected to the third conductive portion of the second conductive region, and the third power chip is located between the first conductive portion and the second conductive portion in the first direction.

6. The semiconductor power module according to claim 5, wherein an edge of the second conductive portion of the first conductive region that faces away from the third conductive region is flush with an edge of the third conductive portion of the first conductive region that faces away from the fourth conductive region, and the third conductive portion of the first conductive region has a width that is greater than a width of the second conductive portion of the first conductive region; and
an edge of the second conductive portion of the second conductive region that faces away from the third conductive region is flush with an edge of the third conductive portion of the second conductive region that faces away from the fourth conductive region, and the third conductive portion of the second conductive region has a width that is greater than a width of the second conductive portion of the second conductive region.

7. The semiconductor power module according to claim 5, wherein an edge of the first conductive portion of the first conductive region that faces away from the third conductive region is flush with an edge of the second conductive portion of the first conductive region that faces away from the fourth conductive region, and the first conductive portion of the first conductive region has a width that is greater than a width of the second conductive portion of the first conductive region; and
an edge of the first conductive portion of the second conductive region that faces away from the third conductive region is flush with an edge of the second conductive portion of the second conductive region that faces away from the fourth conductive region, and the first conductive portion of the second conductive region has a width that is greater than a width of the second conductive portion of the second conductive region.

8. The semiconductor power module according to claim 5, wherein the third conductive region comprises:
a first converging conductive portion (41) extending in the second direction and configured to receive the direct current signal; and
a plurality of first conductive branches (42) connected with the first converging conductive portion and extending towards the fourth conductive region in the first direction;
wherein the first conductive branch is located between the second conductive portion of the first conductive region and the second conductive portion of the second conductive region, and the third power chip is connected to the first conductive branch of the third conductive region.

9. The semiconductor power module according to claim 8, wherein the fourth conductive region comprising:
a second converging conductive portion (51) extending in the first direction and configured to output the alternating current signal;
a plurality of second conductive branches (52) connected with the second converging conductive portion and extending towards the third conductive region in the first direction;
wherein the second converging conductive portion is located between the third conductive portion of the first conductive region and the third conductive portion of the second conductive region, the first power chip (6) and the second power chip (7) are connected to the second converging conductive portion of the fourth conductive region, the second conductive branch is located between the second conductive portion of the first conductive region and the second conductive portion of the second conductive region, and the third power chip is connected to the second conductive branch of the fourth conductive region.

10. The semiconductor power module according to claim 9, wherein the plurality of the first conductive branches and the plurality of the second conductive branches are arranged alternately along the second direction, and the first conductive branch and the second conductive branch that are adjacent to each other are connected through the third power chip.

11. The semiconductor power module according to claim 9 or 10, wherein the first conductive branch and the second conductive branch that are adjacent to each other are connected by a plurality of third power chips that are spaced apart along the first direction, the third power chips located on two outermost sides in the second direction are same in quantity.

12. The semiconductor power module according to any of claims 2 to 11, wherein the first conductive region has a first direct current connection point for receiving the direct current signal, the second conductive region has a second direct current connection point for receiving the direct current signal, the third conductive region has a third direct current connection point for receiving the direct current signal, and the fourth conductive region has an alternating current connection point;
wherein the first direct current connection point, the second direct current connection point, and the third direct current connection point are disposed on one side of the substrate in the first direction and are arranged in the second direction, the third direct current connection point is disposed between the first direct current connection point and the second direct current connection point, a polarity of the direct current signal connected to the first direct current connection point is the same as a polarity of the direct current signal connected to the second direct current connection point, a polarity of the direct current signal connected to the third direct current connection point is opposite to a polarity of the direct current signal connected to the first direct current connection point, and the alternating current connection point is located on the other side of the substrate in the first direction.

13. The semiconductor power module according to claim 12, wherein the first direct current connection point and the second direct current connection point are anodic direct current connection points and the third direct current connection point is a cathode direct current connection point; and
the first power chip is provided in the first conductive region and is electrically connected to the fourth conductive region, the second power chip is provided in the second conductive region and is electrically connected to the fourth conductive region, and the third power chip is provided in the fourth conductive region and is electrically connected to the third conductive region.

14. The semiconductor power module according to claim 12 or 13, wherein the first direct current connection point and the second direct current connection point are cathode direct current connection points and the third direct current connection point is an anodic direct current connection point; and
the first power chip is provided in the fourth conductive region and is electrically connected to the first conductive region, the second power chip is provided in the fourth conductive region and is electrically connected to the second conductive region, and the third power chip is provided in the third conductive region and is electrically connected to the fourth conductive region.

15. The semiconductor power module according to any of claims 1 to 14, wherein a plurality of third power chips are comprised and the plurality of the third power chips are arranged in the first direction or the second direction.

16. The semiconductor power module according to any of claims 1 to 15, wherein the first power chip and the second power chip are arranged in the second direction; and
a plurality of first power chips are comprised, a plurality of second power chips are comprised, and the plurality of the first power chips are arranged in the same direction as that of the plurality of the second power chips.

17. The semiconductor power module according to any of claims 1 to 16, wherein
the first power chip and the third power chip are arranged along the first direction; and
the second power chip and the third power chip are arranged along the first direction.

18. The semiconductor power module according to any of claims 1 to 17, wherein a sum of the number of the at least one first power chip and the number of the at least one second power chip is equal to the number of the at least one third power chip.

19. The semiconductor power module according to any of claims 1 to 18, wherein the first conductive region is connected to the fourth conductive region via a plurality of the first power chips that are spaced apart in the first direction, the second conductive region is connected to the fourth conductive region via a plurality of the second power chips that are spaced apart in the first direction, and the plurality of the first power chips and the plurality of the second power chips are disposed in one-to-one correspondence in the second direction.

20. The semiconductor power module according to any of claims 1 to 19, further comprising:
an insulating cover body mounted on the substrate and covering the first conductive region, the second conductive region, the third conductive region, the fourth conductive region, the at least one first power chip, the at least one second power chip and the at least one third power chip.

21. A motor controller comprising:
a heat-dissipating base plate and a cooling liquid channel, the heat-dissipating base plate mounted to the cooling liquid channel; and
the semiconductor power module according to any one of claims 1-20, wherein the semiconductor power module is disposed on the heat-dissipating base plate.

22. A vehicle comprising:
a motor; and
the motor controller according to claim 21,wherein the motor controller is connected to the motor.
